# EUROPEAN PATENT APPLICATION

(11) **EP 1 500 718 A1**
(43) Date of publication of application: **26.01.2005**
(21) Application number: 04254311.6
(22) Date of filing: 17.07.2004
(51) Int. Cl.: C23C 16/27

(54) **Method for producing diamond film**

(30) Priority: 24.07.2003 JP 2003201018; 24.07.2003 JP 2003201019; 24.07.2003 JP 2003201021
(71) Applicant: Shin-Etsu Chemical Company, Ltd., Tokyo 100-0004 (JP)
(72) Inventor: Noguchi, H., Adv. Funct. Materials Research Center, Annaka-shi Gunma-ken (JP)
(74) Representative: Cooper, John

(57) **Abstract**

The present invention is a method for producing a diamond film on a base material by a vapor phase reaction at least with introducing a raw material gas, wherein PO(OCH₃)₃ gas, P(OCH₃)₃ gas, or B(OC₂H₅)₃ gas is added to the raw material gas as a source of phosphorus or boron to be doped, and a diamond film doped with phosphorus or boron is deposited on the base material by a vapor phase reaction utilizing the mixed raw material gas.

## Description

### BACKGROUND OF THE INVENTION

### Field of the Invention:

The present invention relates to a method for producing a diamond film and a diamond film.

### Related Art:

Diamond films formed on base materials by utilizing unique properties of diamond have been widely investigated. For example, they are investigated as masking members for light exposure in lithography techniques used in the semiconductor device production, substrates for surface acoustic wave (SAW) devices, grinding and polishing tools and so forth.

In recent years, use of diamond films as a masking membrane in the X-ray lithography and electron beam lithography, which enables formation of extremely fine patterns of 100 nm or less, utilizing their properties of high Young's modulus, etching resistance, high-energy ray irradiation resistance and so forth attracts attentions.

As the methods for producing a diamond film, there are known methods of depositing it on a base material by a vapor phase reaction using DC arc discharge, DC glow discharge, combustion flame, radiofrequency wave (R.F.), microwave, hot filament and so forth as an energy source. Among these production methods, the microwave CVD method and the hot filament CVD method are generally used, since they enable formation of films having a large size and good crystallinity.

Meanwhile, a raw material gas used in the aforementioned methods of depositing on a base material by a vapor phase reaction is generally a mixed gas obtained by diluting a carbon-containing gas such as methane, ethylene, acetylene and carbon monoxide with hydrogen gas. Electric resistivity of a diamond film obtained by performing a vapor phase reaction using such a hydrogen-diluted carbon-containing gas as a raw material gas is in the range of 10⁹ to 10¹⁵ Ω·cm.

Further, when a diamond film showing electric resistivity in such a range is used, for example, as a mask for lithography, especially a mask for X-ray or electron beam lithography, a defect test of the mask must be performed by irradiation with an electron beam. But the resistivity is too high for the test, thus a charge up phenomenon is likely to occur due to accumulation of charged particles, and therefore such a defect test cannot be carried out quickly and precisely in many cases.

Moreover, when it is actually used as a mask for electron beam lithography, high resistivity causes a problem in image transfer due to the charge up.

Therefore, in order to avoid such a charge up phenomenon, it has been proposed that a dopant gas such as diborane (B₂H₆) or phosphine (PH₃) is mixed with the aforementioned hydrogen-diluted carbon-containing gas during the production of a diamond film to perform a vapor phase reaction and thereby the electric resistivity of the diamond film is reduced.

Specifically, it is reported that, if B₂H₆ as a source of boron to be doped and hydrogen-diluted methane gas as a raw material gas are mixed, and then such a mixed raw material gas is introduced into a chamber to perform a vapor phase reaction and thereby produce a diamond film of P-type, the electric resistivity value of the diamond film can be decreased to 10⁻² Ω·cm (K. Marumoto, Jpn. J. Appl. Phys., 31 (1992) 4205-4209).

However, if B₂H₆ is used as the source of boron to be doped as described above, influence on human bodies is feared, since the permissible concentration thereof is 0.1 ppm. Further, when PH₃ is used as the source of phosphorus to be doped, influence on human bodies is similarly feared, since the permissible concentration thereof is 0.3 ppm. That is, leakages even in a small amount are not accepted in doping using these gases. Furthermore, since they not only have influence on human bodies but also show explosiveness, they have also a problem concerning handling. In the case that these gases are used in doping, it is necessary to use an apparatus which is provided with an explosion-proof function as well as a leak-proof function preventing a gas leakage even in a small amount. Thus, increase of cost of equipment is unavoidable.

With the purpose of obviating these problems, there has also been proposed a method of adding boron by using a mixed raw material gas obtained by vaporizing a solution dissolving B₂O₃ in methanol, ethanol, acetone or the like and mixing it with a hydrogen diluted carbon-containing gas. However, this technique has a problem that it is difficult to produce a uniform solution and control temperature of the solution, and thus it is difficult to obtain a uniform diamond film with good reproducibility.

### SUMMARY OF THE INVENTION

The present invention was accomplished in view of such problems. Its object is to provide a method enabling easy, inexpensive and uniform production of a diamond film showing low electric resistivity with good reproducibility and having few problems concerning handling such as bad influence on human bodies and explosiveness during the doping process.

The present invention was accomplished in order to solve the aforementioned problem and provides a method for producing a diamond film on a base material by a vapor phase reaction at least with introducing a raw material gas, wherein PO(OCH₃)₃ gas, P(OCH₃)₃ gas, or B(OC₂H₅)₃ gas is added to the raw material gas as a source of phosphorus or boron to be doped, and a diamond film doped with phosphorus or boron is deposited on the base material by a vapor phase reaction utilizing the mixed raw material gas.

If PO(OCH₃)₃ gas, P(OCH₃)₃ gas, or B(OC₂H₅)₃ gas is used as a source of phosphorus or boron to be doped as described above, phosphorus or boron can be easily and uniformly doped, and electric resistivity of the obtained diamond film can be reduced. That is, PO(OCH₃)₃ gas, P(OCH₃)₃ gas, or B(OC₂H₅)₃ gas shows little danger concerning handling such as bad influence on human bodies and explosiveness. Moreover, it enables easy and uniform doping of phosphorus or boron in a diamond film with good reproducibility. Therefore, when this diamond film is used, for example, as a mask for lithography, the charge up phenomenon in the defect test utilizing an electron beam can be avoided, and special apparatuses for ensuring safety are not required, either. Therefore, the film can be produced at a low cost.

In the above method, the PO(OCH₃)₃ gas is preferably added to the raw material gas to be introduced at a volume concentration of more than 0 vol.% but 18 vol.% or less with respect to the total mixed raw material gas.

As described above, if the volume concentration of the PO(OCH₃)₃ gas with respect to the total mixed raw material gas is more than 0 vol.% but 18 vol.% or less, a desired electric resistivity value can be obtained while maintaining high crystallinity of diamond.

In the above method, the P(OCH₃)₃ gas is preferably added to the raw material gas to be introduced at a volume concentration of more than 0 vol.% but 15 vol.% or less with respect to the total mixed raw material gas.

As described above, if the volume concentration of the P(OCH₃)₃ gas with respect to the total mixed raw material gas is more than 0 vol.% but 15 vol.% or less, a desired electric resistivity value can be obtained while maintaining high crystallinity of diamond.

In the above method, the B(OC₂H₅)₃ gas is preferably added to the raw material gas to be introduced at a volume concentration of more than 0 vol.% but 10 vol.% or less with respect to the total mixed raw material gas.

As described above, if the volume concentration of the B(OC₂H₅)₃ gas with respect to the total mixed raw material gas is more than 0 vol.% but 10 vol.% or less, a desired electric resistivity value can be obtained while maintaining high crystallinity of diamond.

In the above method, the doping of phosphorus or boron is preferably controlled so that the electric resistivity of the diamond film is 10⁷ Ω·cm or less at 20°C.

As described above, if the doping of phosphorus or boron is controlled so that the electric resistivity of the diamond film should become 10⁷ Ω ·cm or less at 20°C, when this diamond film is used for a mask for lithography, especially a mask for X-ray or electron beam lithography, the charge up phenomenon can be surely avoided in a defect test of the mask utilizing an electron beam. Thus, such a defect test can be quickly and precisely performed. Therefore, it becomes easy to produce a diamond mask of high quality for lithography by utilizing the diamond film.

Moreover, since the charge up phenomenon can be avoided also when the mask is actually used as a mask for the electron beam lithography, it enables highly precise and highly efficient image transfer.

In the above method, when the diamond film is produced on the base material, only a part of the film may be formed with adding PO(OCH₃)₃ gas to the raw material gas, and the other part of the film may be formed without adding PO(OCH₃)₃ gas to the raw material gas.

As described above, if only a part of the film is formed with adding PO(OCH₃)₃ gas to the raw material gas, and the other part of the film is formed without adding PO(OCH₃)₃ gas to the raw material gas, the amount of PO(OCH₃)₃ used can be reduced. Therefore, the diamond film having desired characteristics can be obtained while minimizing the degradation of the crystallinity, and the cost can also be reduced.

In particular, it is preferable that a part of the film formed with adding PO(OCH₃)₃ gas to the raw material gas is formed as a whole or a part of surface of the diamond film and has a thickness within a range of 20 µm or less.

If a part of the film is formed as described above, the problem of the charge up phenomenon can be settled by the diamond having low electric resistivity formed as a whole or a part of surface of the diamond film. That is, since a problem occurring when a diamond film is used as a mask for lithography, for example, is the charge up phenomenon that charged particles are accumulated on a diamond film surface of the side irradiated with an electron beam, if resistivity in a surface part which has 20µm or less in thickness is lowered, this problem can be settled. Also, since good crystallinity can be maintained in a bulk part, the diamond film of very high quality on the whole can be obtained.

In the above method, when the diamond film is produced on the base material, only a part of the film can be formed with adding P(OCH₃)₃ gas to the raw material gas, and the other part of the film can be formed without adding P(OCH₃)₃ gas to the raw material gas.

As described above, if only a part of the film is formed with adding P(OCH₃)₃ gas to the raw material gas, and the other part of the film is formed without adding P(OCH₃)₃ gas to the raw material gas, the amount of P(OCH₃)₃ used can be reduced. Therefore, desired characteristics can be obtained while minimizing the degradation of the crystallinity, and the cost can also be reduced.

In particular, it is preferable that a part of the film formed with adding P(OCH₃)₃ gas to the raw material gas is formed as a whole or a part of surface of the diamond film and has a thickness within a range of 20 µm or less.

If a part of the film is formed as described above, the problem of the charge up phenomenon can be settled by the diamond having low electric resistivity formed as a whole or a part of surface of the diamond film. That is, since a problem occurring when a diamond film is used for a mask for lithography, for example, is the charge up phenomenon that charged particles are accumulated on a diamond film surface of the side irradiated with an electron beam, if resistivity in a surface part which has 20µm or less in thickness is lowered, this problem can be settled. Also, since good crystallinity can be maintained in a bulk part, the diamond film of very high quality on the whole can be obtained.

In the above method, when the diamond film is produced on the base material, only a part of the film can be formed with adding B(OC₂H₅)₃ gas to the raw material gas, and the other part of the film can be formed without adding B(OC₂H₅)₃ gas to the raw material gas.

As described above, if only a part of the film is formed with adding B(OC₂H₅)₃ gas to the raw material gas, and the other part of the film is formed without adding B(OC₂H₅)₃ gas to the raw material gas, the amount of B(OC₂H₅)₃ gas used can be reduced. Therefore, desired characteristics can be obtained while minimizing the degradation of the crystallinity, and the cost can also be reduced.

In particular, it is preferable that a part of the film formed with adding B(OC₂H₅)₃ gas to the raw material gas is formed as a whole or a part of surface of diamond film and has a thickness within a range of 20 µm or less.

If a part of the film is formed as described above, the problem of the charge up phenomenon can be settled by the diamond having low electric resistivity formed as a whole or a part of surface of the diamond film. That is, since a problem occurring when a diamond film is used for a mask for lithography, for example, is the charge up phenomenon that charged particles are accumulated on a diamond film surface of the side irradiated with an electron beam, if resistivity in a surface part which has 20µm or less in thickness is lowered, this problem can be settled. Also, since good crystallinity can be maintained in a bulk part, the diamond film of very high quality on the whole can be obtained.

Moreover, the present invention provides a diamond film uniformly doped with phosphorus or boron produced by the aforementioned production method. This diamond film has low electric resistivity, and thus it can be used as a mask substrate that is unlikely to cause the charge up phenomenon during the defect test or actual use thereof.

As explained above, according to the present invention, problems concerning danger of handling such as bad influence on human bodies and explosiveness during the doping process are reduced by using PO(OCH₃)₃, P(OCH₃)₃, or B(OC₂H₅)₃ instead of B₂H₆ or PH₃ which is generally used in conventional techniques, and thus special apparatuses as a safety measure become unnecessary. Moreover, the doping can be more easily and more uniformly attained with good reproducibility compared with a case using a vaporized solution of B₂O₃ dissolved in methanol, ethanol, acetone or the like, which is used from the safety conscious viewpoint, as a source of boron to be doped.

As explained above, if PO (OCH₃)₃, P (OCH₃)₃, or B(OC₂H₅)₃ is used and the doping amount of phosphorus or boron is controlled so that the electric resistivity of the diamond film should become 10⁷ Ω ·cm or less, the charge up phenomenon can be surely avoided in a defect test of a mask required when the diamond film is used for a mask for lithography, especially a mask for X-ray or electron beam lithography. Therefore, it becomes possible to produce a diamond mask of high quality for lithography. Moreover, since the charge up phenomenon can be avoided also when the film is actually used as a mask for the electron beam lithography, it enables highly precise and highly efficient image transfer.

### BRIEF EXPLANATION OF THE DRAWING

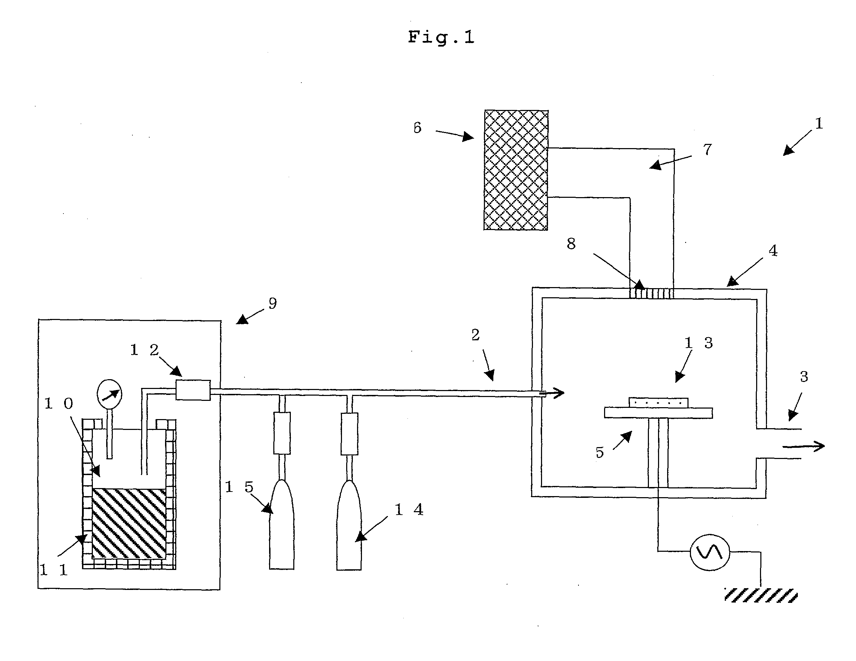

Fig. 1 is a schematic view showing a microwave CVD apparatus used in the present invention.

### PREFERRED EMBODIMENTS OF THE INVENTION

Hereinafter, embodiments of the present invention will be explained. However, the present invention is not limited thereto.

The inventors of the present invention conceived that, in order to easily and uniformly produce a diamond film having low electric resistivity with few problems concerning handling such as serious bad influence on human bodies and explosiveness and with good reproducibility, PO(OCH₃)₃, P(OCH₃)₃, or B (OC₂H₅)₃ could be used as a source of phosphorus or boron to be doped during formation of a vapor phase synthesized diamond film, and thus accomplished the present invention.

At this point, Fig. 1 is a schematic view showing a microwave CVD apparatus, which is a typical apparatus for producing a diamond film, provided with an apparatus for vaporizing and supplying PO(OCH₃)₃, P(OCH₃)₃, or B(OC₂H₅)₃.

In this microwave CVD apparatus 1, a base material stage 5 provided with heating means such as a heater is disposed in a chamber 4 provided with a gas inlet pipe 2 and a gas outlet pipe 3. Further, a microwave power source 6 is connected to a microwave introduction window 8 through a waveguide 7 so that plasma can be generated in the chamber 4. Furthermore, apparatuses for supplying gases are connected at the upper part of the gas inlet pipe 2, and a hydrogen gas supplying tank 14, a carbon-containing gas supplying tank 15 and, in particular, an apparatus 9 for supplying PO(OCH₃)₃ gas, P(OCH₃)₃ gas, or B(OC₂H₅)₃ gas used for the present invention are provided on that side. In this supplying apparatus 9, there are provided a liquid PO(OCH₃)₃, a liquid P(OCH₃)₃, or a liquid B(OC₂H₅)₃ tank 10, a heater 11 for vaporizing PO(OCH₃)₃, P(OCH₃)₃, or B(OC₂H₅)₃, which is liquid at room temperature, and a mass flow controller 12 for precisely controlling the flow rate of PO(OCH₃)₃, P(OCH₃)₃, or B(OC₂H₅)₃.

Hereinafter, the method for producing a diamond film by using PO(OCH₃)₃ gas, P(OCH₃)₃ gas, or B(OC₂H₅)₃ gas as a source of phosphorus or boron to be doped in the production of a diamond film on a base material by a vapor phase reaction with introducing a raw material gas will be explained with reference to Fig. 1.

First, when a diamond film is formed on a base material 13, generation density of diamond nuclei can be increased by providing diamond particles on a base material surface, and thereby formation of a vapor phase synthesized diamond film becomes easy. Therefore, in order to obtain a uniform continuous film even when it is a thin film, it is effective to perform a pretreatment for seeding diamond particles on the base material surface by coating of the base material surface with diamond suspension, ultrasonication with diamond suspension, scratch treatment with diamond particles or the like.

A diamond film can be produced on a base material subjected to such a pretreatment by the vapor phase synthesis method utilizing, for example, DC arc discharge, DC glow discharge, combustion flame, radiofrequency wave (R.F.), microwave, hot filament or the like as an energy source. In particular, the microwave CVD method and the hot filament CVD method are preferred, since they enable formation of films having a large size and good crystallinity.

In the apparatus shown in Fig. 1, the microwave CVD method is used as an example of these vapor phase synthesis methods.

First, the base material 13 subjected to a pretreatment as described above is placed on the base material stage 5, and then inside of the chamber 4 is evacuated by a non-illustrated rotary pump to a pressure of 10⁻³ Torr or less.

Then, a main constitutive raw material gas, for example, a carbon-containing gas such as methane, ethylene, acetylene, and carbon monoxide is supplied from the carbon-containing gas supplying tank 15 at a desired flow rate, and a mixed raw material gas consisting of the raw material gas diluted with hydrogen gas supplied from the hydrogen gas supplying tank 14 and added with PO(OCH₃)₃ gas, P(OCH₃)₃ gas, or B(OC₂H₅)₃ gas according to the present invention at a predetermined concentration is introduced from the inlet pipe 2 into the chamber 4.

At this point, the volume concentration of the PO(OCH₃)₃ gas, which is added to the raw material gas, with respect to the total mixed raw material gas is preferably controlled to be more than 0 vol.% but 18 vol.% or less. The electric resistivity of diamond films formed by the vapor phase reaction using only a raw material gas obtained by diluting a carbon-containing gas such as methane, ethylene, acetylene and carbon monoxide with hydrogen gas is within a range of 10⁹-10¹⁵ Ω·cm. On the other hand, if the vapor phase reaction is performed by using a mixed raw material gas added with PO(OCH₃)₃ gas at a concentration more than 0 vol.%, the electric resistivity of the diamond film to be obtained can be rapidly reduced, and, for example, it can be reduced to 10⁷ Ω·cm or less at 20°C. Moreover, by controlling the concentration of the PO(OCH₃)₃ gas to be 18 vol.% or less, a desired electric resistivity value can be surely obtained while maintaining high crystallinity. On the other hand, if the PO(OCH₃)₃ gas concentration exceeds 18 vol.%, the phosphorus concentration exceeds that of the saturated state, and doping of phosphorus at a concentration exceeding that level is difficult. Even though it is possible, the crystallinity may be markedly degraded or generation of defects may be increased.

And, at this point, the volume concentration of the P(OCH₃)₃ gas, which is added to the raw material gas, with respect to the total mixed raw material gas is preferably controlled to be more than 0 vol.% but 15 vol.% or less. The electric resistivity of the diamond film formed by the vapor phase reaction using only a raw material gas obtained by diluting a carbon-containing gas such as methane, ethylene, acetylene and carbon monoxide with hydrogen gas is within a range of 10⁹-10¹⁵ Ω·cm. On the other hand, if the vapor phase reaction is performed by using a mixed raw material gas added with P(OCH₃)₃ gas at a concentration more than 0 vol.%, the electric resistivity of the diamond film to be obtained can be rapidly reduced, and, for example, it can be reduced to 10⁷ Ω·cm or less at 20°C. Moreover, by controlling the concentration of the P(OCH₃)₃ gas to be 15 vol.% or less, a desired electric resistivity value can be surely obtained while maintaining high crystallinity. On the other hand, if the P(OCH₃)₃ gas concentration exceeds 15 vol.%, the phosphorus concentration exceeds that of the saturated state, and doping of phosphorus at a concentration exceeding that level is difficult. Even though it is possible, the crystallinity may be markedly degraded or generation of defects may be increased.

Also, at this point, the volume concentration of the B(OC₂H₅)₃ gas, which is added to the raw material gas, with respect to the total mixed raw material gas is preferably controlled to be more than 0 vol.% but 10 vol.% or less. The electric resistivity of the diamond film formed by the vapor phase reaction using only a raw material gas obtained by diluting a carbon-containing gas such as methane, ethylene, acetylene and carbon monoxide with hydrogen gas is within a range of 10⁹-10¹⁵ Ω·cm. On the other hand, if the vapor phase reaction is performed by using a mixed raw material gas added with B(OC₂H₅)₃ gas at a concentration more than 0 vol.%, the electric resistivity of the diamond film to be obtained can be rapidly reduced, and, for example, it can be reduced to 10⁷ Ω·cm or less at 20°C. Moreover, by controlling the concentration of the B(OC₂H₅)₃ gas to be 10 vol.% or less, a desired electric resistivity value can be surely obtained while maintaining high crystallinity. On the other hand, if the B(OC₂H₅)₃ gas concentration exceeds 10 vol.%, the boron concentration exceeds that of the saturated state, and doping of boron at a concentration exceeding that level is difficult. Even though it is possible, there is the possibility that the crystallinity is markedly degraded or generation of defects is increased.

Then, after the opening degree of a valve of the gas outlet pipe 3 is adjusted to obtain a pressure of 20 Torr in the chamber 4, microwaves are applied from the microwave power source 6 via the waveguide 7 to generate plasma in the chamber 4 and thereby form a diamond film on the base material 13.

At this point, in order to control the film stress in the diamond film, the base material 13 may be heated by, for example, a heater such as a sintered SiC heater built in the base material stage 5.

Additionally, depending on use conditions of the diamond film, there are some cases that all parts of diamond served as the diamond film do not have to be a phosphorus-doped diamond. In this case, when the diamond film is produced on the base material, only a part of the film can be formed with adding PO(OCH₃)₃ gas to the aforementioned raw material gas, and the other part of the film can be formed without adding PO(OCH₃)₃ gas to the raw material gas. Thereby, the amount of PO(OCH₃)₃ gas used can be reduced, the degradation of crystallinity can be minimized, and the cost can also be reduced.

In particular, there is a problem of the charge up phenomenon that charged particles are accumulated on a diamond film surface of the side irradiated with an electron beam (an interface of the base material side) when the diamond film is irradiated by electron beam in a defect test or when the diamond film is actually used as a mask for the electron beam lithography. Therefore, it is preferable that a part of the film formed with adding PO(OCH₃)₃ gas to the raw material gas is formed as a whole or a part of surface of the diamond film and has a thickness within a range of 20 µm or less, especially has a thickness of 1 µm, at the initial deposition by the CVD reaction. According to this, accumulation of charged particles can be effectively prevented. Also, since the other part of the diamond film (subsequent deposition by the CVD reaction), particularly the bulk part, can be a diamond of high purity, excellent properties of the diamond such as high Young's modulus, etching resistance, high-energy ray irradiation resistance and so forth can be utilized as they are. It is also possible that, in the end of the CVD reaction, PO(OCH₃)₃ gas is introduced to reduce the electric resistivity of the surface of the other side of the diamond film.

Further, depending on use conditions of the diamond film, there are some cases that all parts of diamond served as the diamond film do not have to be a phosphorus-doped diamond. In this case, when the diamond film is produced on the base material, only a part of the film can be formed with adding P(OCH₃)₃ gas to the aforementioned raw material gas, and the other part of the film can be formed without adding P(OCH₃)₃ gas to the raw material gas. Thereby, the amount of P(OCH₃)₃ gas used can be reduced, the degradation of crystallinity can be minimized, and the cost can also be reduced.

In particular, there is a problem of the charge up phenomenon that charged particles are accumulated on a diamond film surface of the side irradiated with an electron beam (an interface of the base material side) when the diamond film is irradiated by electron beam in a defect test or when the diamond film is actually used as a mask for the electron beam lithography. Therefore, it is preferable that a part of the film formed with adding P(OCH₃)₃ gas to the raw material gas is formed as a whole or a part of surface of the diamond film and has a thickness within a range of 20 µm or less, especially has a thickness of 1 µm, at the initial deposition by the CVD reaction. According to this, accumulation of charged particles can be effectively prevented. Also, since the other part of the diamond film (subsequent deposition by the CVD reaction), particularly the bulk part, can be a diamond of high purity, excellent properties of the diamond such as high Young's modulus, etching resistance, high-energy ray irradiation resistance and so forth can be utilized as they are. It is also possible that, in the end of the CVD reaction, P(OCH₃)₃ gas is introduced to reduce the electric resistivity of the surface of the other side of the diamond film.

Furthermore, depending on use conditions of the diamond film, there are some cases that all parts of diamond served as the diamond film do not have to be a phosphorus-doped diamond. In this case, when the diamond film is produced on the base material, only a part of the film can be formed with adding B(OC₂H₅)₃ gas to the aforementioned raw material gas, and the other part of the film can be formed without adding B(OC₂H₅)₃ gas to the raw material gas. Thereby, the amount of B(OC₂H₅)₃ gas used can be reduced, the degradation of crystallinity can be minimized, and the cost can also be reduced.

In particular, there is a problem of the charge up phenomenon that charged particles are accumulated on a diamond film surface of the side irradiated with an electron beam (an interface of the base material side) when the diamond film is irradiated by electron beam in a defect test or when the diamond film is actually used as a mask for the electron beam lithography. Therefore, it is preferable that a part of the film formed with adding B(OC₂H₅)₃ gas to the raw material gas is formed as a whole or a part of surface of the diamond film and has a thickness within a range of 20 µm or less, especially has a thickness of 1 µm, at the initial deposition by the CVD reaction. According to this, accumulation of charged particles can be effectively prevented. Also, since the other part of the diamond film (subsequent deposition by the CVD reaction), particularly the bulk part, can be a diamond of high purity, excellent properties of the diamond such as high Young's modulus, etching resistance, high-energy ray irradiation resistance and so forth can be utilized as they are. It is also possible that, in the end of the CVD reaction, B(OC₂H₅)₃ gas is introduced to reduce the electric resistivity of the surface of the other side of the diamond film.

By replacing B₂H₆ or PH₃, conventionally and generally used as the source to be doped, with PO(OCH₃)₃, P(OCH₃)₃, or B (OC₂H₅)₃ as described above, problems concerning danger of handling such as serious bad influence on human bodies and explosiveness are ameliorated, and thus special apparatuses for safety become unnecessary. Moreover, it becomes possible to more easily and more uniformly perform doping with better reproducibility compared with a case where a solution dissolving B₂O₃, which has been used from the safety conscious viewpoint, in methanol, ethanol, acetone or the like is vaporized and used as the source to be doped.

Also, by adjusting the concentration of the PO(OCH₃)₃ gas, P(OCH₃)₃ gas, or B(OC₂H₅)₃ gas added to the raw material gas, the electric resistivity value of the diamond film to be produced can be controlled. In particular, if it is adjusted so that the electric resistivity of the diamond film should become 10⁷ Ω·cm or less, the charge up phenomenon can surely be avoided in a defect test of a mask which is required when the diamond film is used as a mask for lithography, especially a mask for X-ray or electron beam lithography. Thus, it becomes possible to produce a diamond mask for lithography of high quality. Moreover, when the film is actually used as a diamond mask for electron beam lithography, the charge up phenomenon can also be avoided. Thus it becomes possible to perform highly precise and highly efficient image transfer, and semiconductor devices of higher precision and higher integration can be attained.

### EXAMPLES

Hereinafter, the present invention will be specifically explained with reference to Examples and a Comparative Example.

### (Example 1)

A single crystal silicon wafer having a diameter of 100 mm, thickness of 2 mm and crystal orientation of <100>, of which both surfaces were polished, was prepared as a base material and subjected to a pretreatment in order to improve the generation density of diamond nuclei. First, the base material was adsorbed on a spin coater by vacuum suction, and 50 ml of suspension of diamond particles (cluster diamonds having a mean particle size of 50 nm) was dropped onto the surface. The wafer was rotated at 3000 rpm for 30 seconds to obtain uniformly coated state of the suspension of diamond particles on the surface. Then, the coated suspension was air-dried to form a seeded layer of diamond on the base material surface. After the pretreatment was performed as described above, the base material was set on the base material stage in the chamber of the microwave CVD apparatus shown in Fig. 1.

Then, after reduced pressure of 10⁻³ Torr or less was obtained by evacuation using a rotary pump, a mixed raw material gas consisting of methane gas, hydrogen gas and PO(OCH₃)₃ gas was supplied from the gas inlet pipe. The gases were introduced into the chamber at 40.0 sccm for methane gas, 890.0 sccm for hydrogen gas and 70.0 sccm for PO(OCH₃)₃ gas to obtain a volume ratio of methane gas/hydrogen gas/PO(OCH₃)₃ gas = 4.0/89.0/7.0. Then, opening degree of the valve of the gas outlet pipe was controlled to obtain a pressure of 20 Torr in the chamber, and plasma was generated by applying microwaves of 3000 W to form a phosphorus-doped diamond film on the base material for 8 hours.

During the film formation, the base material generated heat due to absorption of the microwaves, and the surface temperature reached 860°C.

A phosphorus-doped diamond film obtained as described above was finished by polishing. In a 35 mm square region at the center of the base material, the thickness was 2.0 µm ± 0.1 µm, stress was 92 MPa ± 13 MPa, and surface roughness was 2 nm in terms of Ra, and thus they were at highly practically useful levels. In addition, little fluctuation was observed among batches, which was practically very advantageous.

Furthermore, the above diamond film formed substrate was processed into a mask substrate for electron beam lithography, and a stencil type mask for electron beam lithography was produced by using the mask substrate. Then, the value of electric resistivity of the diamond film was measured, and it was found to be 7 Ω·cm. Thus, even when a defect test of the mask was performed, the charge up phenomenon was not caused. Moreover, also when it was actually used as a mask for electron beam lithography, there was no charge up phenomenon, and stable and highly precise image transfer was possible.

### (Example 2)

A single crystal silicon wafer having a diameter of 100 mm, thickness of 2 mm and crystal orientation of <100>, of which both surfaces were polished, was prepared as a base material and subjected to a pretreatment in order to improve the generation density of diamond nuclei. First, the base material was adsorbed on a spin coater by vacuum suction, and 50 ml of suspension of diamond particles (cluster diamonds having a mean particle size of 50 nm) was dropped onto the surface. The wafer was rotated at 3000 rpm for 30 seconds to obtain uniformly coated state of the suspension of diamond particles on the surface. Then, the coated suspension was air-dried to form a seeded layer of diamond on the base material surface. After the pretreatment was performed as described above, the base material was set on the base material stage in the chamber of the microwave CVD apparatus shown in Fig. 1.

Then, after reduced pressure of 10⁻³ Torr or less was obtained by evacuation using a rotary pump, a mixed raw material gas consisting of methane gas, hydrogen gas and P(OCH₃)₃ gas was supplied from the gas inlet pipe. The gases were introduced into the chamber at 40.0 sccm for methane gas, 910.0 sccm for hydrogen gas and 50.0 sccm for P(OCH₃)₃ gas to obtain a volume ratio of methane gas/hydrogen gas/PO(OCH₃)₃ gas = 4.0/91.0/5.0. Then, opening degree of the valve of the gas outlet pipe was controlled to obtain a pressure of 20 Torr in the chamber, and plasma was generated by applying microwaves of 3000 W to form a phosphorus-doped diamond film on the base material for 7.7 hours.

During the film formation, the base material generated heat due to absorption of the microwaves, and the surface temperature reached 860°C.

A phosphorus-doped diamond film obtained as described above was finished by polishing. In a 35 mm square region at the center of the base material, the thickness was 2.0 µm ± 0.1 µm, stress was 87 MPa ± 15 MPa, and surface roughness was 2 nm in terms of Ra, and thus they were at highly practically useful levels. In addition, little fluctuation was observed among batches, which was practically very advantageous.

Furthermore, the above diamond film formed substrate was processed into a mask substrate for electron beam lithography, and a stencil type mask for electron beam lithography was produced by using the mask substrate. Then, the value of electric resistivity of the diamond film was measured, and it was found to be 5.2 Ω·cm. Thus, even when a defect test of the mask was performed, the charge up phenomenon was not caused. Moreover, also when it was actually used as a mask for electron beam lithography, there was no charge up phenomenon, and stable and highly precise image transfer was possible.

### (Example 3)

A single crystal silicon wafer having a diameter of 100 mm, thickness of 2 mm and crystal orientation of <100>, of which both surfaces were polished, was prepared as a base material and subjected to a pretreatment in order to improve the generation density of diamond nuclei. First, the base material was adsorbed on a spin coater by vacuum suction, and 50 ml of suspension of diamond particles (cluster diamonds having a mean particle size of 50 nm) was dropped onto the surface. The wafer was rotated at 3000 rpm for 30 seconds to obtain uniformly coated state of the suspension of diamond particles on the surface. Then, the coated suspension was air-dried to form a seeded layer of diamond on the base material surface. After the pretreatment was performed as described above, the base material was set on the base material stage in the chamber of the microwave CVD apparatus shown in Fig. 1.

Then, after reduced pressure of 10⁻³ Torr or less was obtained by evacuation using a rotary pump, a mixed raw material gas consisting of methane gas, hydrogen gas and B(OC₂H₅)₃ gas was supplied from the gas inlet pipe. The gases were introduced into the chamber at 40.0 sccm for methane gas, 930.0 sccm for hydrogen gas and 30.0 sccm for B(OC₂H₅)₃ gas to obtain a volume ratio of methane gas/hydrogen gas/ B(OC₂H₅)₃ gas = 4.0/93.0/3.0. Then, opening degree of the valve of the gas outlet pipe was controlled to obtain a pressure of 20 Torr in the chamber, and plasma was generated by applying microwaves of 3000 W to form a boron-doped diamond film on the base material for 7 hours.

During the film formation, the base material generated heat due to absorption of the microwaves, and the surface temperature reached 860°C.

A boron-doped diamond film obtained as described above was finished by polishing. In a 35 mm square region at the center of the base material, the thickness was 2.0 µm ± 0.1 µm, stress was 90 MPa ± 13 MPa, and surface roughness was 2 nm in terms of Ra, and thus they were at highly practically useful levels. In addition, little fluctuation was observed among batches, which was practically very advantageous.

Furthermore, the above diamond film formed substrate was processed into a mask substrate for electron beam lithography, and a stencil type mask for electron beam lithography was produced by using the mask substrate. Then, the value of electric resistivity of the diamond film was measured, and it was found to be 0.8 Ω·cm. Thus, even when a defect test of the mask was performed, the charge up phenomenon was not caused. Moreover, also when it was actually used as a mask for electron beam lithography, there was no charge up phenomenon, and stable and highly precise image transfer was possible.

### (Comparative Example 1)

A diamond film was formed in the same manner as in the Example 1 except that the P(OCH₃)₃ gas was not used as a source to be doped, but a solution dissolving B₂O₃ in ethanol was vaporized to add to the raw material gas. That is, a boron-doped diamond film was formed on the base material for 13 hours by introducing into the chamber a mixed raw material gas having a composition (methane gas/hydrogen gas/B₂O₃ = 1.0/97.0/2.0 vol.%), by which a diamond film showing crystallinity (confirmed by the Raman spectrometry) and electric resistivity (confirmed by the four-terminal method) of the same levels as those obtained in the Examples 1-3 on the surface of the silicon wafer subjected to the pretreatment where the diamond suspension was spin-coated can be obtained, and applying microwaves of 3000 W at 20 Torr to generate plasma. Then, the wafer was polished. Although the obtained diamond showed a reduced resistivity of 30 Ω·cm, thickness and stress showed bad uniformity, i.e., the thickness was 2.0 µm ± 0.5 µm and the stress was 187 MPa ± 77 MPa in a 35 mm square region at the center of the base material.

Moreover, fluctuation of the concentration of the B₂O₃ solution in ethanol was observed as the B₂O₃ solution was consumed, and temperature control was strictly required during the process. Thus, it was extremely difficult to obtain a uniformly doped diamond film in terms of uniformity in a film and among batches. Furthermore, a large amount of generated B₂O₃ particles adhered, and thus it was disadvantageous also in view of prevention of defect generation.

### (PH₃ doping)

First of all, when a diamond film having characteristics of the same levels is formed by using PH₃ gas as a source to be doped without using PO(OCH₃)₃ gas or P(OCH₃)₃ gas, a safety measure for apparatuses to be prepared must be completely different from those of the Examples 1-2. That is, the permissible concentration of PH₃ for human bodies is 0.3 ppm, and it shows extremely high explosiveness, i.e., the explosion limit thereof is 0.8 to 98.0 vol.%. Therefore, enormous cost is required for installations for preventing leakage of PH₃. Moreover, in order to obtain a conductivity of the same level as that of the Examples 1-2, PH₃ must be added at a concentration of several vol.%, and it is an extremely dangerous concentration.

After all, since use of PH₃ was too unpractical taking economy, safety and characteristics of diamond to be obtained into consideration, a comparison test was given up.

### (B₂H₆ doping)

First of all, when a diamond film having characteristics of the same levels is formed by using B₂H₆ gas as a source to be doped without using B(OC₂H₅)₃ gas, a safety measure for apparatuses to be prepared must be completely different from those of the Example 3. That is, the permissible concentration of B₂H₆ for human bodies is 0.1 ppm, and it shows extremely high explosiveness, i.e., the explosion limit thereof is 0.9 to 98.0 vol.%. Therefore, enormous cost is required for installations for preventing leakage of B₂H₆. Moreover, in order to obtain a conductivity of the same level as that of the Example 3, B₂H₆ must be added at a concentration of several vol.%, and it is an extremely dangerous concentration.

After all, since use of B₂H₆ was too unpractical taking economy, safety and characteristics of diamond to be obtained into consideration, a comparison test was given up.

The present invention is not limited to the embodiments described above. The above-described embodiments are mere examples, and those having substantially the same configuration as that described in the appended claims and providing the similar functions and advantages are included in the scope of the present invention.

For example, while the use of the diamond film of the present invention was explained for the case where it is used as a masking member for X-ray or electron beam lithography, the present invention is not limited to this use.

## Claims

1. A method for producing a diamond film on a base material by a vapor phase reaction at least with introducing a raw material gas, wherein PO(OCH₃)₃ gas, P(OCH₃) gas, or B(OC₂H₅)₃ gas is added to the raw material gas as a source of phosphorus or boron to be doped, and a diamond film doped with phosphorus or boron is deposited on the base material by a vapor phase reaction utilizing the mixed raw material gas.

2. The method for producing a diamond film according to Claim 1, wherein a volume concentration of the PO(OCH₃)₃ gas added to the raw material gas is more than 0 vol.% but 18 vol.% or less with respect to the total mixed raw material gas.

3. The method for producing a diamond film according to Claim 1, wherein a volume concentration of the P(OCH₃)₃ gas added to the raw material gas is more than 0 vol.% but 15 vol.% or less with respect to the total mixed raw material gas.

4. The method for producing a diamond film according to Claim 1, wherein a volume concentration of the B(OC₂H₅)₃ gas added to the raw material gas is more than 0 vol.% but 10 vol.% or less with respect to the total mixed raw material gas.

5. The method for producing a diamond film according to any one of Claims 1-4, wherein the doping of phosphorus or boron is controlled so that an electric resistivity of the diamond film is 10⁷ Ω ·cm or less at 20°C.

6. The method for producing a diamond film according to any one of Claims 1, 2, or 5, wherein when the diamond film is produced on the base material, only a part of the film is formed with adding PO(OCH₃)₃ gas to the raw material gas, and the other part of the film is formed without adding PO(OCH₃)₃ gas to the raw material gas.

7. The method for producing a diamond film according to Claim 6, wherein a part of the film formed with adding PO(OCH₃)₃ gas to the raw material gas is formed as a whole or a part of surface of the diamond film and has a thickness within a range of 20 µm or less.

8. The method for producing a diamond film according to any one of Claims 1, 3, or 5, wherein when the diamond film is produced on the base material, only a part of the film can be formed with adding P(OCH₃)₃ gas to the raw material gas, and the other part of the film can be formed without adding P(OCH₃)₃ gas to the raw material gas.

9. The method for producing a diamond film according to Claim 8, wherein a part of the film formed with adding P(OCH₃)₃ gas to the raw material gas is formed as a whole or a part of surface of the diamond film and has a thickness within a range of 20 µm or less.

10. The method for producing a diamond film according to any one of Claims 1, 4, or 5, wherein when the diamond film is produced on the base material, only a part of the film can be formed with adding B(OC₂H₅)₃ gas to the raw material gas, and the other part of the film can be formed without adding B(OC₂H₅)₃ gas to the raw material gas.

11. The method for producing a diamond film according to Claim 10, wherein a part of the film formed with adding B(OC₂H₅)₃ gas to the raw material gas is formed as a whole or a part of surface of the diamond film and has a thickness within a range of 20 µm or less.

12. A diamond film produced by a method according to any one of Claims 1-11.

13. A mask substrate utilizing the diamond film according to Claim 12.
